# EUROPEAN PATENT APPLICATION

(11) **EP 4 482 266 A1**
(43) Date of publication of application: **25.12.2024**
(21) Application number: 22927014.5
(22) Date of filing: 16.02.2022
(51) Int. Cl.: H05K 3/10, H05K 3/12, H05K 3/28, H05K 3/32

(54) **ELECTRICAL CIRCUIT FORMATION METHOD, AND ELECTRICAL CIRCUIT FORMATION DEVICE**

(71) Applicant: Fuji Corporation, Chiryu-shi, Aichi 472-8686 (JP)
(72) Inventor: TSUKADA, Kenji, Chiryu-shi, Aichi 472-8686 (JP)
(74) Representative: Grünecker Patent- und Rechtsanwälte PartG mbB
(86) International application number: PCT/JP2022/006096
(87) International publication number: WO 2023/157111

(57) **Abstract**

An electrical circuit formation method including a wiring forming step of forming a metal wiring on a resin layer, an applying step of applying a conductive fluid on the metal wiring, a mounting step of mounting an electronic component such that an electrode comes into contact with the conductive fluid applied in the applying step, and a coating body forming step of forming a coating body with a curable resin to cover a periphery of the electronic component mounted in the mounting step, in which in the applying step, the conductive fluid is applied continuously in a direction in which the metal wiring extends, from a planned mounting position of the electrode to a position that extends out of an outer edge of the electronic component.

## Description

### Technical Field

The present invention relates to an electrical circuit formation method and an electrical circuit formation device in which an electronic component is mounted such that an electrode comes into contact with a conductive fluid applied onto a metal wiring, and a coating body is formed with a curable resin so as to cover the periphery of the electronic component.

### Background Art

The following Patent Literature describes a technique of mounting an electronic component such that an electrode comes into contact with a conductive fluid applied onto a metal wiring.

### Patent Literature

Patent Literature 1: JP-A-2002-359460

### Summary of the Invention

### Technical Problem

An object of the present invention is to appropriately ensure conduction of a metal wiring in an electrical circuit in which an electronic component is mounted such that an electrode comes into contact with a conductive fluid applied onto the metal wiring, and a coating body is formed with a curable resin so as to cover the periphery of the electronic component.

### Solution to Problem

In order to solve the above problems, the present description discloses an electrical circuit formation method including a wiring forming step of forming a metal wiring on a resin layer, an applying step of applying a conductive fluid on the metal wiring, a mounting step of mounting an electronic component such that an electrode comes into contact with the conductive fluid applied in the applying step, and a coating body forming step of forming a coating body with a curable resin to cover a periphery of the electronic component mounted in the mounting step, in which in the applying step, the conductive fluid is applied continuously in a direction in which the metal wiring extends, from a planned mounting position of the electrode to a position that extends out of an outer edge of the electronic component.

In order to solve the above problems, the present description discloses an electrical circuit formation device including a wiring formation device configured to form a metal wiring on a resin layer, a fluid applying device configured to apply a conductive fluid on the metal wiring, a mounting device configured to mount an electronic component such that an electrode comes into contact with the conductive fluid applied by the fluid applying device, and a resin applying device configured to apply a curable resin to cover a periphery of the electronic component mounted by the mounting device, in which the fluid applying device is configured to apply the conductive fluid continuously in a direction in which the metal wiring extends, from a planned mounting position of the electrode to a position that extends out of an outer edge of the electronic component.

### Advantageous Effects of the Invention

In the present disclosure, the conductive fluid is applied continuously in the direction in which the metal wiring extends, from the planned mounting position of the electrode to the position that extends out of the outer edge of the electronic component. As a result, it is possible to reduce the force applied to the metal wiring located below the portion in contact with the electronic component and the coating body, and to appropriately ensure the conduction of the metal wiring.

### Brief Description of Drawings

Fig. 1 is a diagram illustrating a circuit formation device.
Fig. 2 is a block diagram illustrating a control device.
Fig. 3 is a cross-sectional view illustrating a circuit in a state where a resin laminate is formed.
Fig. 4 is a cross-sectional view illustrating the circuit in a state where a wiring is formed on the resin laminate.
Fig. 5 is a cross-sectional view illustrating the circuit in a state where a second resin laminate is formed on a first resin laminate so that an end portion of the wiring is exposed.
Fig. 6 is a cross-sectional view illustrating the circuit in a state where a conductive resin paste is applied onto the wiring.
Fig. 7 is a cross-sectional view illustrating the circuit in a state where an electronic component is mounted.
Fig. 8 is a cross-sectional view illustrating the circuit in a state where a thermosetting resin is discharged around the electronic component.
Fig. 9 is a cross-sectional view illustrating the circuit in a state where a crack is generated in the wiring.
Fig. 10 is a cross-sectional view illustrating the circuit in a state where the conductive resin paste is applied onto the wiring.
Fig. 11 is a plan view illustrating a lower surface of the electronic component.
Fig. 12 is a diagram illustrating a planned mounting position of the electrode and the conductive resin paste which is extended from the planned mounting position in an extending direction of the wiring and discharged.
Fig. 13 is a cross-sectional view illustrating the circuit in a state where the thermosetting resin is discharged around the electronic component.
Fig. 14 is a plan view illustrating the lower surface of the electronic component.
Fig. 15 is a diagram illustrating a planned mounting position of the electrode and the conductive resin paste which is extended from the planned mounting position in an extending direction of the wiring and discharged.

### Description of Embodiments

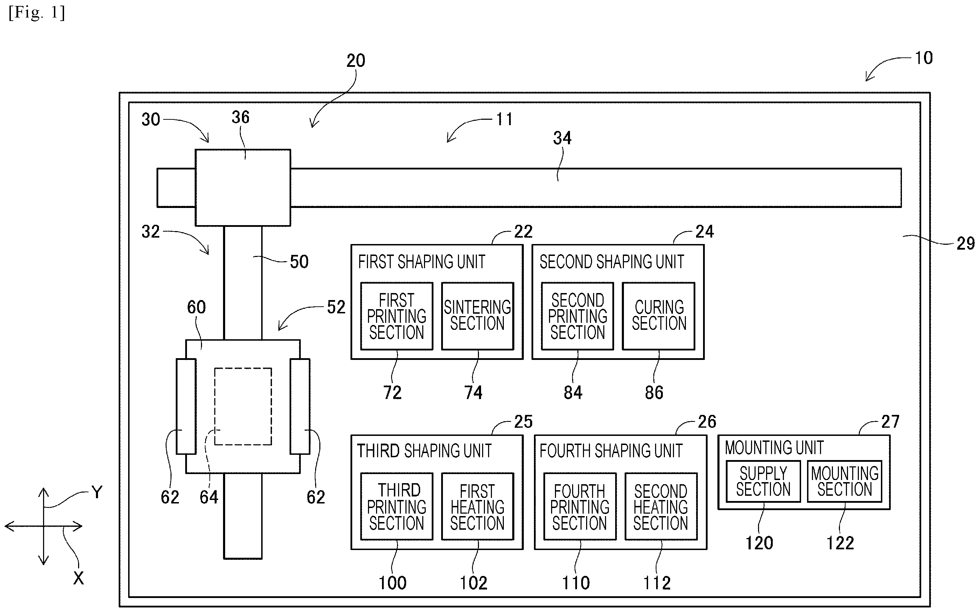

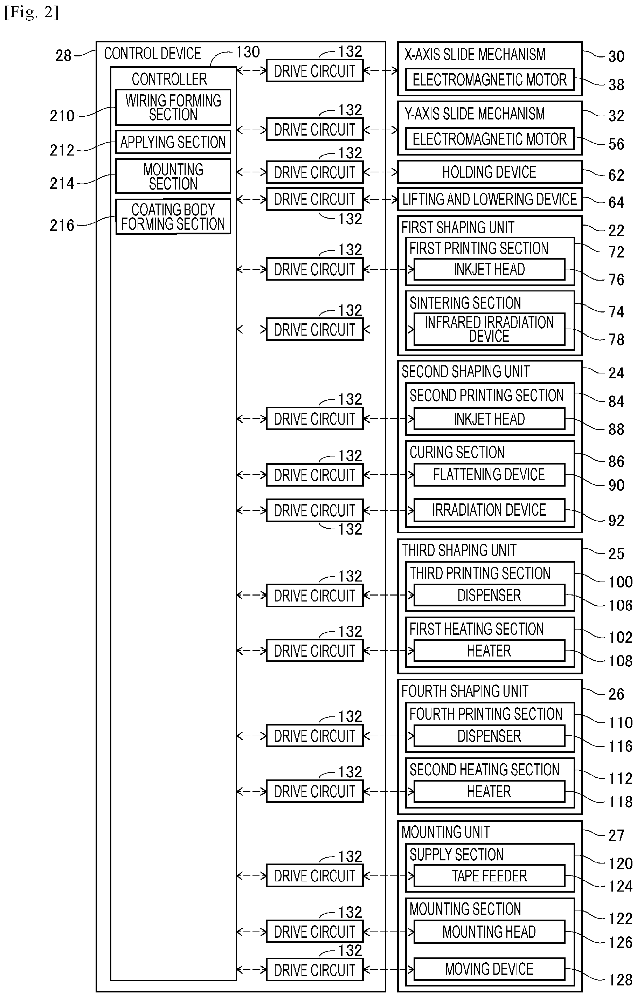

Fig. 1 illustrates circuit formation device 10. Circuit formation device 10 includes conveyance device 20, first shaping unit 22, second shaping unit 24, third shaping unit 25, fourth shaping unit 26, mounting unit 27, and control device 28 (refer to Fig. 2). Conveyance device 20, first shaping unit 22, second shaping unit 24, third shaping unit 25, fourth shaping unit 26, and mounting unit 27 are disposed on base 29 of circuit formation device 10. Base 29 has a generally rectangular shape, and in the following description, a longitudinal direction of base 29 will be referred to as an X-axis direction, a shorter direction of base 29 will be referred to as a Y-axis direction, and a direction orthogonal to both the X-axis direction and the Y-axis direction will be referred to as a Z-axis direction.

Conveyance device 20 is provided with X-axis slide mechanism 30 and Y-axis slide mechanism 32. X-axis slide mechanism 30 includes X-axis slide rail 34 and X-axis slider 36. X-axis slide rail 34 is disposed on base 29 to extend in the X-axis direction. X-axis slider 36 is held by X-axis slide rail 34 to be slidable in the X-axis direction. Furthermore, X-axis slide mechanism 30 includes electromagnetic motor 38 (refer to Fig. 2), and X-axis slider 36 is moved to any position in the X-axis direction by driving electromagnetic motor 38. In addition, Y-axis slide mechanism 32 includes Y-axis slide rail 50 and stage 52. Y-axis slide rail 50 is disposed on base 29 to extend in the Y-axis direction and is movable in the X-axis direction. One end portion of Y-axis slide rail 50 is coupled to X-axis slider 36. Stage 52 is held on Y-axis slide rail 50 to be slidable in the Y-axis direction. Furthermore, Y-axis slide mechanism 32 includes electromagnetic motor 56 (refer to Fig. 2), and stage 52 is moved to any position in the Y-axis direction by driving electromagnetic motor 56. As a result, stage 52 is moved to any position on base 29 with the driving of X-axis slide mechanism 30 and Y-axis slide mechanism 32.

Stage 52 includes base plate 60, holding devices 62, and lifting and lowering device 64. Base plate 60 is formed in a flat plate shape, and a board is placed on an upper surface of base plate 60. Holding devices 62 are provided on both side portions of base plate 60 in the X-axis direction. The board is fixedly held by sandwiching both edge portions of the board placed on base plate 60 in the X-axis direction with holding devices 62. In addition, lifting and lowering device 64 is disposed below base plate 60, and lifts and lowers base plate 60.

First shaping unit 22 is a unit that shapes a wiring on the board placed on base plate 60 of stage 52, and has first printing section 72 and sintering section 74. First printing section 72 includes inkjet head 76 (refer to Fig. 2), and inkjet head 76 linearly discharges metal ink. The metal ink is ink obtained by dispersing nanometer-sized metal fine particles, for example, silver fine particles in a solvent. A surface of the metal fine particle is coated with a dispersant and aggregation in the solvent is prevented. In addition, inkjet head 76 discharges the metal ink from multiple nozzles by, for example, a piezo type using a piezoelectric element.

Sintering section 74 includes infrared irradiation device 78 (refer to Fig. 2). Infrared irradiation device 78 is a device for irradiating the discharged metal ink with infrared light, and the metal ink irradiated with infrared light is sintered to form the wiring. Sintering of the metal ink is a phenomenon in which the solvent is vaporized, or the protective film of metal fine particles, that is, the dispersant is decomposed by applying energy, so that conductivity is increased by contacting or fusing the metal fine particles. The metal ink is sintered to form a metal wiring.

Second shaping unit 24 is a unit that shapes a resin layer on the board placed on base plate 60 of stage 52, and has second printing section 84 and curing section 86. Second printing section 84 includes inkjet head 88 (refer to Fig. 2), and inkjet head 88 discharges an ultraviolet curable resin. The ultraviolet curable resin is a resin that is cured by irradiation with ultraviolet light. Inkjet head 88 may be, for example, a piezo type using a piezoelectric element, or may be a thermal type in which a resin is heated to generate air bubbles, which are discharged from multiple nozzles.

Curing section 86 includes flattening device 90 (refer to Fig. 2) and irradiation device 92 (refer to Fig. 2). Flattening device 90 flattens an upper surface of the ultraviolet curable resin discharged by inkjet head 88, and makes the thickness of the ultraviolet curable resin uniform, for example, by scraping off excess resin by a roller or a blade while leveling the surface of the ultraviolet curable resin. In addition, irradiation device 92 includes a mercury lamp or LED as a light source, and irradiates the discharged ultraviolet curable resin with ultraviolet light. As a result, the discharged ultraviolet curable resin is cured to form the resin layer.

Third shaping unit 25 is a unit that shapes a connection section between an electrode of an electronic component and the wiring on the board placed on base plate 60 of stage 52, and includes third printing section 100 and first heating section 102. Third printing section 100 includes dispenser 106 (refer to Fig. 2), and dispenser 106 discharges conductive resin paste. The conductive resin paste is a paste in which micrometer-sized metal particles are dispersed in a resin cured by heating at a relatively low temperature. Incidentally, the metal particles are flake-shaped, and the viscosity of the conductive resin paste is relatively higher than that of the metal ink.

First heating section 102 includes heater 108 (refer to Fig. 2). Heater 108 is a device that heats the conductive resin paste applied by dispenser 106, and a resin is cured in the heated conductive resin paste. At this time, in the conductive resin paste, the resin is cured and contracted, and the dispersed flake-shaped metal particles contact the resin. As a result, the conductive resin paste exhibits conductivity. In addition, the resin of the conductive resin paste is an organic adhesive, and exhibits an adhesive force when cured by heating.

Fourth shaping unit 26 is a unit that shapes a resin for fixing a periphery of an electronic component to be described later, and includes fourth printing section 110 and second heating section 112. Fourth printing section 110 includes dispenser 116 (refer to Fig. 2), and dispenser 116 discharges the thermosetting resin. The thermosetting resin is a resin that is cured by heating. Dispenser 116 is, for example, a piezo type using a piezoelectric element. In addition, second heating section 112 includes heater 118 (refer to Fig. 2). Heater 118 is a device that heats the discharged thermosetting resin, and the heated thermosetting resin is cured.

Mounting unit 27 is a unit that mounts an electronic component on the board placed on base plate 60 of stage 52, and includes supply section 120 and mounting section 122. Supply section 120 includes multiple tape feeders 124 (refer to Fig. 2) that feed the taped electronic components one by one, and supplies the electronic component at the supply position. Supply section 120 is not limited to tape feeder 124, and may be a tray-type supply device that supplies the electronic component by picking up the electronic component from a tray. In addition, supply section 120 may include both of the tape-type supply device and the tray-type supply device, or other supply devices.

Mounting section 122 includes mounting head 126 (refer to Fig. 2) and moving device 128 (refer to Fig. 2). Mounting head 126 includes a suction nozzle (not illustrated) for picking up and holding the electronic component. The suction nozzle picks up and holds the electronic component by suction of air as negative pressure is supplied from a positive and negative pressure supply device (not illustrated). When slight positive pressure is supplied from the positive and negative pressure supply device, the electronic component is separated. In addition, moving device 128 moves mounting head 126 between the supply position of the electronic component by tape feeder 124 and the board placed on base plate 60. As a result, in mounting section 122, the electronic component supplied from tape feeder 124 is held by the suction nozzle, and the electronic component held by the suction nozzle is mounted on the board.

As illustrated in Fig. 2, control device 28 includes controller 130 and multiple drive circuits 132. Multiple drive circuits 132 are connected to electromagnetic motors 38 and 56, holding device 62, lifting and lowering device 64, inkjet head 76, infrared irradiation device 78, inkjet head 88, flattening device 90, irradiation device 92, dispenser 106, heater 108, dispenser 116, heater 118, tape feeder 124, mounting head 126, and moving device 128. Controller 130 includes CPU, ROM, RAM, and the like, mainly includes a computer, and is connected to multiple drive circuits 132. As a result, the operations of conveyance device 20, first shaping unit 22, second shaping unit 24, third shaping unit 25, fourth shaping unit 26, and mounting unit 27 are controlled by controller 130.

With the configuration described above, in circuit formation device 10, a resin laminate is formed on base plate 60, and a wiring is formed on the upper surface of the resin laminate. The electrode of the electronic component is electrically connected to the wiring via the conductive resin paste, and the electronic component is fixed with the resin to form a circuit board.

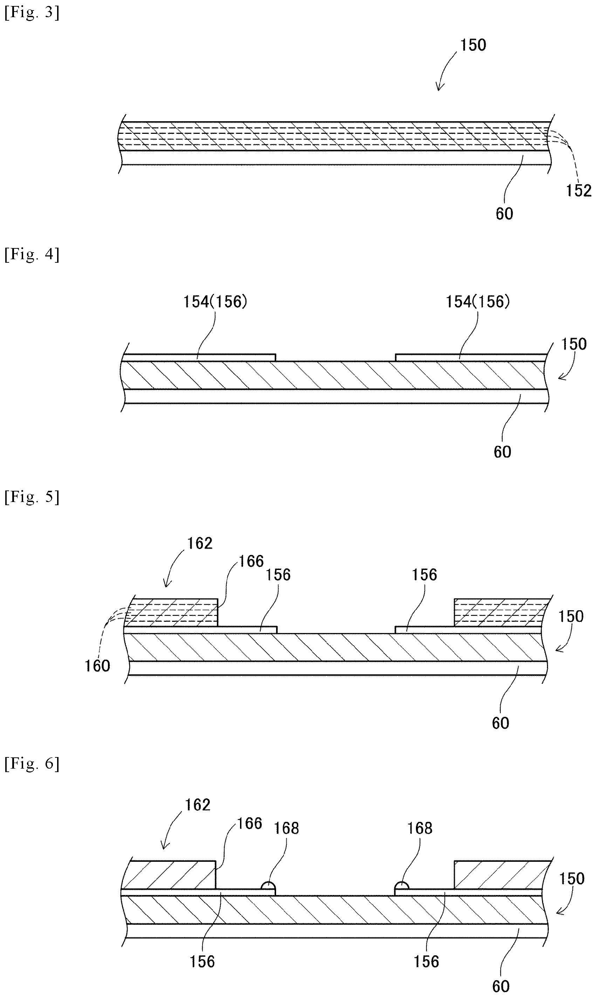

Specifically, stage 52 is moved below second shaping unit 24. In second shaping unit 24, as illustrated in Fig. 3, resin laminate 150 is formed on base plate 60 of stage 52. Resin laminate 150 is formed by repeating the discharge of the ultraviolet curable resin from inkjet head 88 and the irradiation of the discharged ultraviolet curable resin with the ultraviolet light by irradiation device 92.

More specifically, in second printing section 84 of second shaping unit 24, inkjet head 88 discharges the ultraviolet curable resin in a thin film shape on the upper surface of base plate 60. Subsequently, when the ultraviolet curable resin is discharged in a thin film shape, the ultraviolet curable resin is flattened by flattening device 90 in curing section 86 so that the ultraviolet curable resin has a uniform film thickness. Irradiation device 92 irradiates the ultraviolet curable resin in a thin film shape with ultraviolet light. As a result, thin film-shaped resin layer 152 is formed on base plate 60.

Subsequently, inkjet head 88 discharges the ultraviolet curable resin in a thin film shape onto thin film-shaped resin layer 152. The ultraviolet curable resin in a thin film shape is flattened by flattening device 90, and irradiation device 92 irradiates the ultraviolet curable resin discharged in a thin film shape with ultraviolet light, and thus resin layer 152 in a thin film shape is laminated on resin layer 152 in a thin film shape. As described above, the discharge of the ultraviolet curable resin on thin film-shaped resin layer 152 and the irradiation with the ultraviolet light are repeated, and multiple resin layers 152 are laminated, and thus resin laminate 150 is formed.

When resin laminate 150 is formed by the above-described procedure, stage 52 is moved below first shaping unit 22. In first printing section 72 of first shaping unit 22, as illustrated in Fig. 4, inkjet head 76 linearly discharges metal ink 154 on the upper surface of resin laminate 150 in accordance with a circuit pattern. Subsequently, in sintering section 74 of first shaping unit 22, infrared irradiation device 78 irradiates metal ink 154 discharged in accordance with the circuit pattern with infrared light. As a result, metal ink 154 is sintered, and wiring 156 is formed on resin laminate 150.

Next, stage 52 is moved below second shaping unit 24. In second shaping unit 24, inkjet head 88 discharges the ultraviolet curable resin in a thin film shape so that the end portion of wiring 156 is exposed. Subsequently, when the ultraviolet curable resin is discharged in a thin film shape, the ultraviolet curable resin is flattened in curing section 86 so that the ultraviolet curable resin has a uniform film thickness. Irradiation device 92 irradiates the ultraviolet curable resin in a thin film shape with ultraviolet light. As a result, as illustrated in Fig. 5, resin layer 160 is formed on resin laminate 150.

Subsequently, inkjet head 88 discharges the ultraviolet curable resin only on a portion on resin layer 160 in a thin film shape. That is, inkjet head 88 discharges the ultraviolet curable resin in a thin film shape onto resin layer 160 so that the end portion of wiring 156 is exposed. The ultraviolet curable resin in a thin film shape is flattened by flattening device 90, irradiation device 92 irradiates the ultraviolet curable resin discharged in a thin film shape with ultraviolet light, and thus resin layer 160 is laminated on resin layer 160. As described above, the discharge of the ultraviolet curable resin on resin layer 160 and the irradiation with the ultraviolet light are repeated, and multiple resin layers 160 are laminated, and thus resin laminate 162 is formed. As a result, resin laminate 162 is formed on resin laminate 150, and a step portion between resin laminate 150 and resin laminate 162 functions as cavity 166.

As described above, when resin laminate 162 is formed on resin laminate 150, stage 52 is moved below third shaping unit 25. In third printing section 100 of third shaping unit 25, dispenser 106 discharges conductive resin paste 168 onto the end portion of wiring 156, as illustrated in Fig. 6. As described above, when conductive resin paste 168 is discharged onto the end portion of wiring 156, conductive resin paste 168 is heated by heater 108 in first heating section 102 of third shaping unit 25. As a result, conductive resin paste 168 exhibits conductivity.

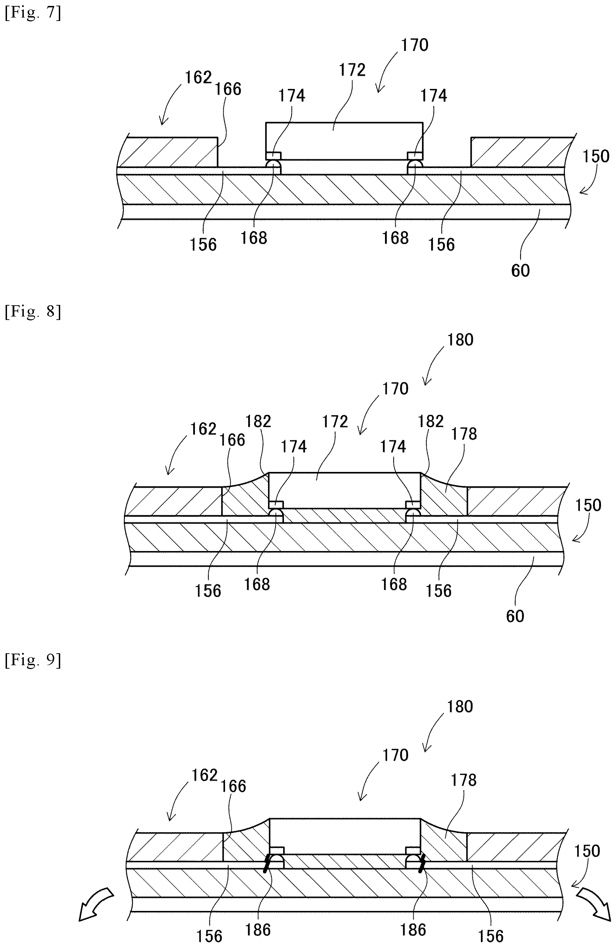

Subsequently, stage 52 is moved below mounting unit 27. In mounting unit 27, electronic component 170 (refer to Fig. 7) is supplied by tape feeder 124, and electronic component 170 is held by the suction nozzle of mounting head 126. Electronic component 170 includes component main body 172 and two electrodes 174 disposed on the lower surface of component main body 172. Mounting head 126 is moved by moving device 128, and electronic component 170 held by the suction nozzle is mounted on the upper surface of resin laminate 150 in the inside of cavity 166, as illustrated in Fig. 7. At this time, electronic component 170 is mounted on the upper surface of resin laminate 150 such that electrode 174 of electronic component 170 comes into contact with conductive resin paste 168 discharged onto wiring 156. That is, conductive resin paste 168 is discharged to a planned mounting position of electrode 174 of electronic component 170, and electronic component 170 is mounted such that electrode 174 comes into contact with conductive resin paste 168.

As described above, when electronic component 170 is mounted on resin laminate 150 in the inside of cavity 166, stage 52 is moved below fourth shaping unit 26. In fourth printing section 110 of fourth shaping unit 26, dispenser 116 discharges thermosetting resin 178 to the inside of cavity 166 as illustrated in Fig. 8. At this time, dispenser 116 discharges thermosetting resin 178 to the inside of cavity 166 so as to cover the space between the lower surface of component main body 172 of electronic component 170 mounted on the inside of cavity 166 and the upper surface of resin laminate 150 and the side surface of component main body 172. As a result, wiring 156 exposed in the inside of cavity 166 is also covered with thermosetting resin 178. In second heating section 112, thermosetting resin 178 is heated by heater 118, so that thermosetting resin 178 is sealed between the upper surface of resin laminate 150 and the lower surface of component main body 172, and is cured in a state of covering the side surface of component main body 172. As a result, circuit board 180 is formed on the upper surface of base plate 60 by fixing electronic component 170 mounted on the inside of cavity 166 with the cured resin.

As described above, in circuit formation device 10, circuit board 180 is formed by performing irradiation of the ultraviolet light to the ultraviolet curable resin, heating of the thermosetting resin, heating of the conductive resin paste, and the like. However, since circuit board 180 is formed of materials having different coefficients of linear expansion, and when circuit board 180 is formed, heating of the thermosetting resin, heating of the conductive resin paste, and the like are repeatedly performed, stress due to the difference in coefficient of linear expansion is repeatedly generated. Specifically, since the coefficient of linear expansion of electronic component 170 mounted on the inside of cavity 166 is different from the coefficient of thermal expansion of thermosetting resin 178 filled in the inside of cavity 166, stress due to the difference in coefficient of linear expansion is repeatedly generated on contact surface 182 between electronic component 170 and thermosetting resin 178. Therefore, stress concentrates on wiring 156 located below contact surface 182 between electronic component 170 and thermosetting resin 178. In addition, since the coefficient of linear expansion of the ultraviolet curable resin, which is the material of resin laminates 150 and 162, is different from the coefficient of linear expansion of electronic component 170 and thermosetting resin 178 in the inside of cavity 166, circuit board 180 may be warped in a crying shape. The crying warpage is a warpage in a convex shape, and when circuit board 180 is warped in the crying shape, a tensile force is generated in wiring 156. Therefore, as illustrated in Fig. 9, the stress generated on contact surface 182 between electronic component 170 and thermosetting resin 178 may concentrate on a portion located below contact surface 182 of the wiring in a pulled state, and crack 186 may be generated in the portion.

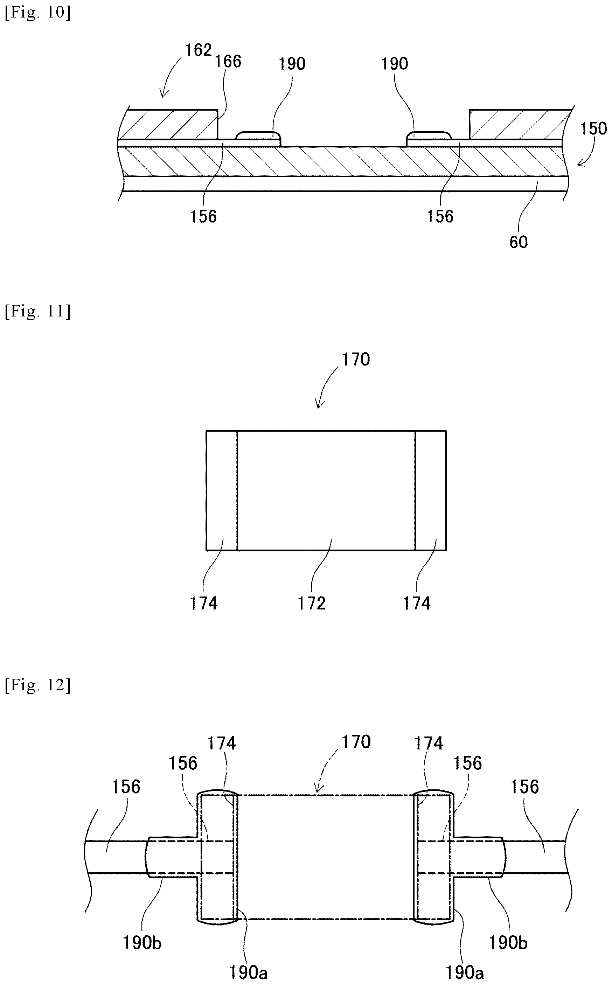

In view of this fact, in the conventional method, as illustrated in Fig. 6, conductive resin paste 168 is discharged to the planned mounting position of electrode 174 of electronic component 170, but as a new method, as illustrated in Fig. 10, conductive resin paste 190 is discharged to extend from the planned mounting position of electrode 174 in the direction in which wiring 156 extends. Specifically, as described above, electronic component 170 includes component main body 172 and two electrodes 174 disposed on the lower surface of component main body 172, and is a rectangular electronic component, a so-called chip component, having two electrodes 174 on both edges of component main body 172 in the longitudinal direction. As illustrated in Fig. 11, two electrodes 174 are disposed along both edges of component main body 172 in the longitudinal direction. Fig. 11 is a plan view illustrating the lower surface of electronic component 170.

Then, as illustrated in Fig. 12, conductive resin paste 190a is discharged to a planned mounting position corresponding to electrode 174, that is, a planned mounting position having the length corresponding to the dimension of electrode 174 in length. In Fig. 12, the planned mounting position of electronic component 170 and the planned mounting position of electrode 174 are indicated by one-dot chain lines. In addition, wiring 156 is formed so as to be orthogonal to the extending direction of the planned mounting position of electrode 174, and conductive resin paste 190b is continuously discharged, in a direction in which wiring 156 extends, from the planned mounting position of electrode 174 to a position that extends out of the outer edge of the planned mounting position of electronic component 170. As a result, conductive resin paste 190 is discharged in a generally T-shape. The dimension of conductive resin paste 190b in width is larger than the dimension of wiring 156 in width, and conductive resin paste 190b covers wiring 156 in the width direction. In addition, the dimension of conductive resin paste 190b in length is 100 µm to 600 µm. That is, conductive resin paste 190b is discharged to a position that extends out of the outer edge of the planned mounting position of electronic component 170 by 100 µm to 600 µm.

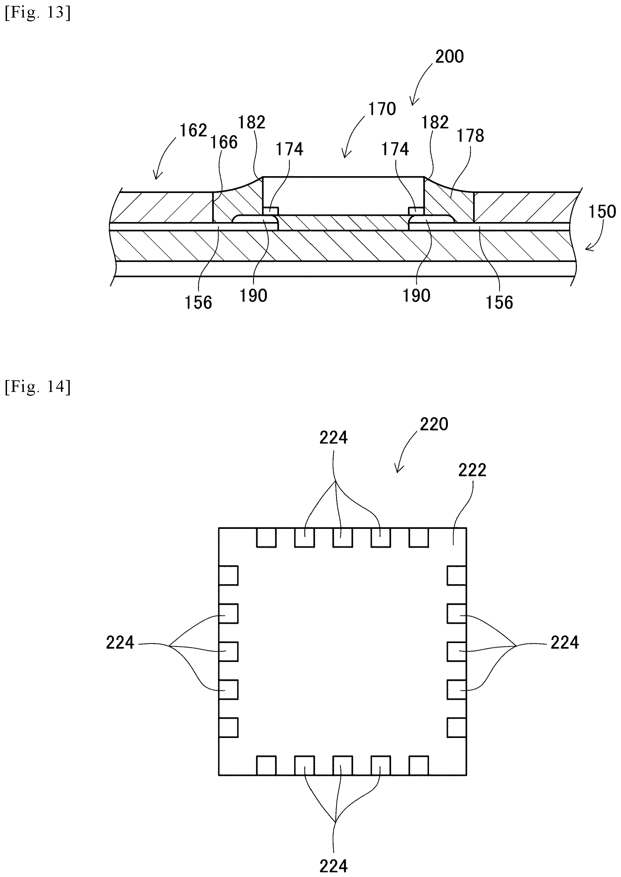

As described above, when conductive resin paste 190 is discharged in a generally T-shape, conductive resin paste 190 is heated by heater 108. As illustrated in Fig. 13, electronic component 170 is mounted such that electrode 174 comes into contact with conductive resin paste 190, and thermosetting resin 178 is discharged to the inside of cavity 166. As a result, circuit board 200 is formed. In circuit board 200 formed in this manner, conductive resin paste 190 is continuously discharged, in a direction in which wiring 156 extends, from below electrode 174 to the position that extends out of the outer edge of electronic component 170. Therefore, conductive resin paste 190 is located below contact surface 182 between electronic component 170 and thermosetting resin 178, and wiring 156 is disposed below conductive resin paste 190. Therefore, the stress generated in contact surface 182 between electronic component 170 and thermosetting resin 178 is blocked by conductive resin paste 190, so that it is difficult to transmit the stress to wiring 156. As a result, it is possible to reduce the stress applied to wiring 156 and to appropriately prevent wiring 156 from cracking.

In addition, Young's modulus of conductive resin paste 190 is the lowest among the materials constituting circuit board 200. Young's modulus is a constant of proportionality between strain and stress in the elastic range, and is a ratio of the stress to the strain. Therefore, in a case where an object having a high Young's modulus and an object having a low Young's modulus are deformed at the same stress, the object having a low Young's modulus deforms more than the object having a high Young's modulus. That is, an object having a low Young's modulus is easily deformed. Therefore, conductive resin paste 190 having a low Young's modulus can suitably receive the stress generated on contact surface 182 between electronic component 170 and thermosetting resin 178, and can appropriately prevent the crack of wiring 156. Furthermore, the tensile force on wiring 156 generated when circuit board 200 is warped in a crying shape is also reduced by conductive resin paste 190 having a low Young's modulus. As a result, it is possible to appropriately prevent wiring 156 from cracking.

In addition, conductive resin paste 190a is discharged to a planned mounting position having the length corresponding to the dimension of electrode 174 of electronic component 170 in the longitudinal direction. Therefore, when electronic component 170 is mounted, electrode 174 entirely contacts conductive resin paste 190a. As a result, it is possible to prevent mounted electronic component 170 from wobbling and to stably mount electronic component 170.

As illustrated in Fig. 2, controller 130 of control device 28 includes wiring forming section 210, applying section 212, mounting section 214, and coating body forming section 216. Wiring forming section 210 is a functional section for forming wiring 156 on resin laminate 150. Applying section 212 is a functional section for continuously applying conductive resin paste 190, in the direction in which wiring 156 extends, from the planned mounting position of electrode 174 to the position that extends out of the outer edge of electronic component 170. Mounting section 214 is a functional section for mounting electronic component 170 such that conductive resin paste 190a and electrode 174 come into contact with each other. Coating body forming section 216 is a functional section for forming thermosetting resin 178 so as to cover the periphery of electronic component 170 in the inside of cavity 166.

In the above example, circuit formation device 10 is an example of an electrical circuit formation device. First shaping unit 22 is an example of a wiring formation device. Mounting unit 27 is an example of a mounting device. Dispenser 106 is an example of a fluid applying device. Dispenser 116 is an example of a resin applying device. Resin laminate 150 is an example of a resin layer. Wiring 156 is an example of a metal wiring. Electronic component 170 is an example of an electronic component. Component main body 172 is an example of a component main body. Electrode 174 is an example of an electrode. Thermosetting resin 178 is an example of a curable resin and a coating body. Conductive resin paste 190 is an example of a conductive fluid. In addition, a step executed by wiring forming section 210 is an example of a wiring forming step. A step executed by applying section 212 is an example of an applying step. A step executed by mounting section 214 is an example of a mounting step. A step executed by coating body forming section 216 is an example of a coating body forming step.

The present invention is not limited to the example described above, and can be performed in various aspects to which various modifications and improvements are applied based on the knowledge of those skilled in the art. For example, although circuit board 200 on which electronic component 170 is mounted is formed in the above example, a circuit board on which electronic components of various shapes are mounted may be formed. Specifically, for example, a circuit board on which electronic component 220 illustrated in Fig. 14 is mounted may be formed. Electronic component 220 includes component main body 222 and multiple electrodes 224 disposed on the lower surface of component main body 222. Multiple electrodes 224 are arranged side by side on four sides of the lower surface of component main body 222, and electronic component 220 is a so-called quad flat non-leaded package (QFN) component. Fig. 14 is a plan view illustrating the lower surface of electronic component 220.

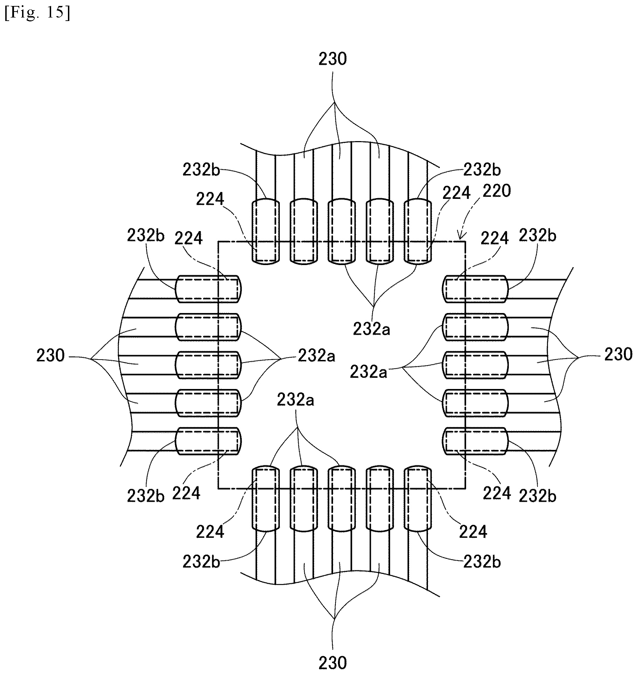

When such electronic component 220 is mounted, as illustrated in Fig. 15, multiple wirings 230 are formed in accordance with the positions of multiple electrodes 224 of electronic component 220. In Fig. 15, the planned mounting position of electronic component 220 and the planned mounting position of electrode 174 are indicated by one-dot chain lines. Conductive resin paste 232a is discharged to the planned mounting position of electrode 224 of electronic component 220. In addition, conductive resin paste 232b is continuously discharged, in the direction in which wiring 230 extends, from the planned mounting position of electrode 224 to a position that extends out of the outer edge of the planned mounting position of electronic component 220. Electronic component 220 is mounted such that electrode 224 comes into contact with conductive resin paste 232a. As described above, even by discharging conductive resin paste 232 to the planned mounting position of electrode 224 and continuously discharging resin paste 232, in the direction in which wiring 230 extends, from the planned mounting position of electrode 224 to the position that extends out of the outer edge of the planned mounting position of electronic component 220, the crack of wiring 230 can be appropriately prevented.

In the above example, thermosetting resin 178 is adopted as the curable resin for fixing electronic component 170, but various resins such as ultraviolet curable resin and two-liquid mixed resin can be adopted.

In the above example, conductive resin pastes 190 and 232 are adopted as the conductive fluid, but various fluids may be adopted as long as the conductivity is exhibited.

In the above example, conductive resin paste is discharged by dispenser 106, but may be transferred by a transfer device or the like. In addition, conductive resin paste may be printed by screen printing.

### Reference Signs List

10: Circuit formation device (electrical circuit formation device), 22: First shaping unit (wiring formation device), 27: Mounting unit (mounting device), 106: Dispenser (fluid applying device), 116: Dispenser (resin applying device), 150: Resin laminate (resin layer), 156: Wiring (metal wiring), 170: Electronic component, 172: Component main body, 174: Electrode, 178: Thermosetting resin (curable resin) (coating body), 190: Conductive resin paste (conductive fluid), 210: Wiring forming section (wiring forming step), 212: Applying section (applying step), 214: Mounting section (mounting step), 216: Coating body forming section (coating body forming step), 220: Electronic component, 222: Component main body, 224: Electrode, 230: Wiring (metal wiring), 232: Conductive resin paste (conductive fluid).

## Claims

1. An electrical circuit formation method comprising:
a wiring forming step of forming a metal wiring on a resin layer;
an applying step of applying a conductive fluid on the metal wiring;
a mounting step of mounting an electronic component such that an electrode comes into contact with the conductive fluid applied in the applying step; and
a coating body forming step of forming a coating body with a curable resin to cover a periphery of the electronic component mounted in the mounting step,
wherein
in the applying step, the conductive fluid is applied continuously in a direction in which the metal wiring extends, from a planned mounting position of the electrode to a position that extends out of an outer edge of the electronic component.

2. The electrical circuit formation method according to claim 1, wherein
the electronic component includes a component main body and the electrode disposed on a bottom surface of the component main body.

3. The electrical circuit formation method according to claim 2, wherein
the electronic component is a rectangular electronic component including the electrodes at both edges of the component main body in a longitudinal direction, and
in the applying step, the conductive fluid is applied to the planned mounting position corresponding to the electrodes and is applied continuously in the direction in which the metal wiring intersecting with the electrodes extends, from the planned mounting position to the position that extends out of the outer edge of the electronic component, such that the conductive fluid has a T-shape.

4. The electrical circuit formation method according to any one of claims 1 to 3, wherein
in the applying step, the conductive fluid is applied continuously in the direction in which the metal wiring extends, from the planned mounting position of the electrode to a position that extends out of the outer edge of the electronic component by 100 µm to 600 µm.

5. An electrical circuit formation device comprising:
a wiring formation device configured to form a metal wiring on a resin layer;
a fluid applying device configured to apply a conductive fluid on the metal wiring;
a mounting device configured to mount an electronic component such that an electrode comes into contact with the conductive fluid applied by the fluid applying device; and
a resin applying device configured to apply a curable resin to cover a periphery of the electronic component mounted by the mounting device,
wherein
the fluid applying device is configured to apply the conductive fluid continuously in a direction in which the metal wiring extends, from a planned mounting position of the electrode to a position that extends out of an outer edge of the electronic component.
